# FASCICULE DE BREVET EUROPEEN

(11) **EP 1 192 594 B1**
(45) Date de publication et mention de la délivrance du brevet: **01.10.2003**
(21) Numéro de dépôt: 00949618.3
(22) Date de dépôt: 03.07.2000
(51) Int. Cl.: G06K 19/077

(54) **PROCEDE DE FABRICATION DE CARTES LAMINEES MUNIES D'UNE COUCHE INTERMEDIAIRE DE PETG**
HERSTELLUNGSVERFAHREN EINER LAMINIERTEN KARTE MIT EINER ZWISCHENSCHICHT AUS PETG
METHOD FOR MAKING LAMINATED CARDS PROVIDED WITH AN INTERMEDIATE PETG LAYER

(30) Priorité: 01.07.1999 FR 9908506
(43) Date de publication de la demande: 03.04.2002
(73) Titulaire: SCHLUMBERGER Systèmes, 92542 Montrouge (FR)
(72) Inventeur: VERE, Denis, F-45000 Orléans (FR); DANIEL, Eric, F-45650 Saint Jean Le Blanc (FR)
(74) Mandataire: den Braber, Gerard Paul
(86) Numéro de dépôt international: FR0001896
(87) Numéro de publication internationale: WO01003061

(56) Documents cités:
- EP-A- 0 640 940
- EP-A- 0 706 152

## Description

La présente invention a trait à un procédé de fabrication de cartes laminées ainsi qu'à des cartes obtenues selon un tel procédé.

Les cartes selon l'invention sont des cartes à puce comportant d'une part, un corps de carte plastique et, d'autre part, un module électronique intégré audit corps de carte et comprenant un circuit intégré dont des plots sont connectés à des plages de contact affleurantes à la surface du corps de carte et/ou à des bornes d'une antenne noyée dans ledit corps de carte.

De telles cartes sont notamment destinées au traitement ou à l'enregistrement de données confidentielles en vue, par exemple, de la réalisation de transactions électroniques dans des domaines variés tels que les domaines de la santé, de la télévision dite à péage, de la téléphonie ou du domaine bancaire.

Elles sont généralement personnalisées de manière à identifier leur porteur et présentent ainsi à cet effet des motifs imprimés.

Pour la fabrication des cartes, différents procédés sont connus. Certains procédés procèdent par laminage à chaud. Selon ces procédés, les différentes couches constitutives du corps de carte sont assemblées à des pressions et températures données telles que les matières plastiques qui les constituent atteignent leur point Vicat et s'interpénètrent localement pour donner des ensembles laminés sensiblement cohérents. Ces ensembles sont ensuite imprimés puis découpés aux dimensions requises d'un corps de carte. Une cavité est alors fraisée dans chacun desdits corps et un module électronique est finalement reporté collé dans ladite cavité.

Dans ces procédés, les matières constitutives des différentes couches connues sont : l'acrylonitrile butadiène styrène (ABS), le polychlorure de vinyle (PVC), des mélanges ABS/PVC, le polyéthylène téréphtalate (PET), le polyéthylène téréphtalate glycol (PETG) et le polycarbonate (PC). Bien souvent, les différentes couches constitutives du corps de carte sont d'une même nature chimique, par exemple, toutes en PVC. En particulier, les différentes couches superposées des cartes en PETG connues sont en PETG.

Les procédés de fabrication des cartes de l'état de la technique, ainsi que les cartes obtenues selon de tels procédés, présentent cependant différents inconvénients.

Notamment, les cartes en ABS, PVC, en mélange ABS/PVC, en PET et en PC montrent des tenues limitées aux flexions dynamiques en longueur et en largeur. En général, elles se fissurent au bout d'environ 1500 flexions dynamiques en longueur avec une flèche de 20 mm centrée sur le corps de carte puis d'environ 1500 flexions dynamiques en largeur avec une flèche centrée de 10 mm.

Ce n'est cependant pas le cas des cartes en PETG qui montrent a contrario une bonne tenue aux flexions précitées. Néanmoins, compte tenu de la faible viscosité du PETG aux conditions de température et de pression usuelles du laminage, il est nécessaire, à une pression donnée, de réduire les températures de laminage si l'on souhaite éviter tous les inconvénients de fluage du PETG dans les dispositifs de laminage. Or, à de telles températures réduites, la cohérence des ensembles laminés obtenus s'avère médiocre et il est pratiquement difficile de trouver un juste milieu qui permette d'éviter à la fois les problèmes de fluage du PETG et ces inconvénients de cohérence desdits ensembles laminés.

L' invention objet de la demande de brevet EP-A-0640 940, utilisé pour la forme en deux parties, concerne quant à elle une carte à puce sans contacts comprenant un corps de carte comprenant une antenne couplée à un circuit électronique. Le corps de carte est composé de deux couches extérieures et d'une couche intermédiaire intercalée entre les deux couches extérieures. La couche intermédiaire comprend l'antenne et le circuit électronique. Chaque couche extérieure est liée à la couche intermédiaire au moyen d'une couche liante dont le point de fusion est inférieur à celui desdites couches extérieures.

Compte tenu de ce qui précède, un problème que se propose de résoudre l'invention est de réaliser une carte comportant, d'une part, un corps de carte comprenant au moins trois couches plastiques laminées directement superposées les unes aux autres, la seconde couche étant placée entre la première et la troisième couche et, d'autre part, un module électronique incorporé audit corps de carte, ledit module comprenant un circuit intégré, ladite carte présentant une bonne tenue aux flexions dynamiques et pour la réalisation de laquelle les inconvénients de fluage et de cohérence sont correctement maîtrisés.

Considérant le problème précité, la solution de l'invention a pour premier objet un procédé de fabrication d'une telle carte, caractérisé en ce que, la seconde couche étant une couche de polyéthylène téréphtalate glycol et les première et troisième couches étant de nature différente de ladite seconde couche, - on lamine les première, seconde et troisième couches de manière à obtenir un premier ensemble laminé ; - on ménage une cavité débouchant sur la seconde couche ; et - on reporte le module dans ladite cavité.

Ainsi, le PETG, qui est retenu entre les première et troisième couches, ne flue pas lors du laminage.

La carte obtenue présente de surcroît une bonne cohérence, les plastiques des trois couches ayant atteints leur point vicat et la résistance aux flexions dynamiques de ladite carte s'avère bien meilleure que celle des cartes de l'état de la technique.

De manière avantageuse, le procédé selon l'invention comporte en outre l'étape ultérieure suivante selon laquelle - on lamine ledit premier ensemble laminé, dans lequel on a reporté le module, à des conditions de pression et de température telles que le PETG atteigne son point Vicat, de manière à obtenir un second ensemble laminé.

Le PETG, qui montre une faible viscosité aux conditions définies ci-dessus, vient alors combler l'espace compris entre les bords de la cavité et des bords dudit module, ce qui assure un bon maintien de ce dernier dans le corps de carte.

Un autre avantage qui découle de cette étape apparaît lorsque, selon un mode de mise en oeuvre particulier de l'invention, le second laminage est effectué en présence d'une quatrième couche plastique. Cette couche plastique ne subit pas les déformations habituellement rencontrées.

On notera que l'invention a par ailleurs pour second objet une carte, caractérisée en ce que ladite seconde couche est une couche de polyéthylène téréphtalate glycol et en ce que les première et troisième couches sont de nature chimique différente de ladite seconde couche.

L'invention sera mieux comprise à la lecture de l'exposé non limitatif qui suit, rédigé au regard des dessins annexé, dans lesquels:
la figure 1 montre, en perspective, une carte selon l'invention ;
la figure 2 montre, en coupe transversale, une carte selon l'invention ;
la figure 3 illustre, en coupe transversale, une étape de laminage selon l'invention ;
la figure 4 illustre, en coupe transversale, une étape de report du module selon l'invention ; et
la figure 5 illustre, en coupe transversale, une étape de laminage selon l'invention.

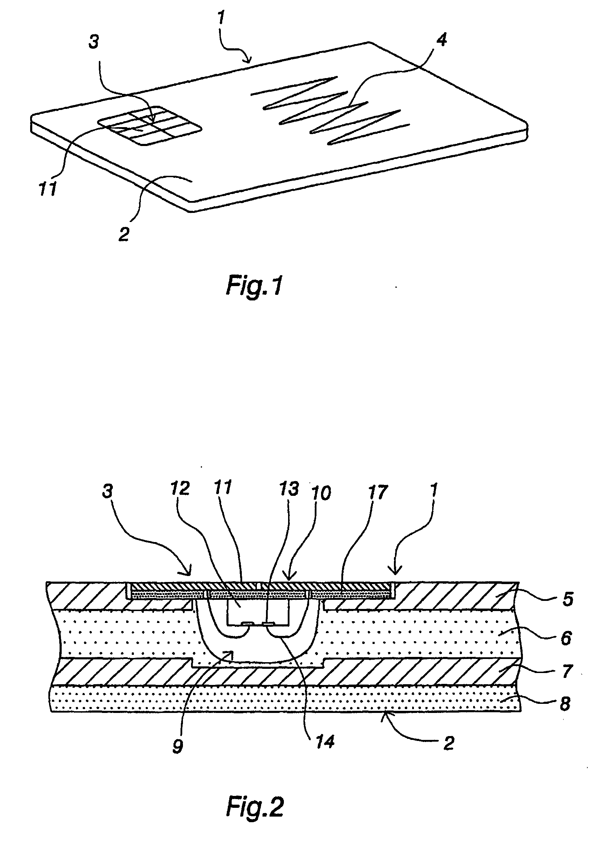

Telle que montrée à la figure 1, une carte 1 selon l'invention comporte, d'une part, un corps 2 de carte et, d'autre part, un module 3 électronique incorporé audit corps 2 de carte.

Le corps 2 de carte se présente sous la forme d'un parallélépipéde rectangle dont les dimensions, définies dans la norme ISO7816 dont le contenu est incorporé au présent exposé par citation de référence, sont de l'ordre de 85,6 mm de longueur, 54 mm de largeur et 0,8 mm d'épaisseur.

Il est formé de différentes couches plastiques laminées directement superposées les unes aux autres. On entend par "directement superposées" le fait que les couches plastiques sont directement en contact les unes avec les autres ou en contact entre elles par un adhésif.

Il est par ailleurs généralement imprimé de motifs 4 d'impression et par exemple d'un code barre ou de données biométriques ou d'une photographie du titulaire de la carte 1. De tels motifs 4 peuvent être apparents à l'une quelconque ou aux deux faces principales du corps 2 de carte.

Dans le mode de réalisation montré à la figure 2, le corps 2 de carte se compose de quatre couches plastiques directement superposées. Il s'agit d'une première 5, d'une seconde 6, d'une troisième 7 et d'une quatrième 8 couches plastiques. La première couche 5 est une couche thermoplastique de PVC dont le point Vicat est de l'ordre de 73°C et dont l'épaisseur est d'environ 190 µm. La seconde couche 6 est une couche thermoplastique de PETG dont le point Vicat est de l'ordre de 70°C et dont l'épaisseur est d'environ 190 µm. La troisième couche 7 est une couche thermoplastique de PVC dont le point Vicat est de l'ordre de 73°C et dont l'épaisseur est d'environ 240 µm. La quatrième couche 8 est une couche plastique dont l'épaisseur est de l'ordre de 175 µm et qui peut être formée d'un PVC ou de toute autre matière plastique transparente. La première couche 5 est directement superposée à la seconde couche 6, qui est elle-même directement superposée à la troisième couche 7 et qui est elle-même directement superposée à la quatrième couche 8. La seconde couche 6 en PETG est ainsi placée entre les première 5 et troisième 7 couches de PVC. Ces première 5 et troisième 7 couches sont de nature chimique différente du PETG de la seconde couche.

Le module 3 électronique est incorporé au corps 2 de carte dans une position définie par exemple dans la norme ISO précitée. Ce module 3 comporte deux parties principales : un corps 9 de module noyé dans le corps 2 de carte et non visible de l'extérieur et une partie 10 supérieure dite de contact comprenant des plages 11 de contact affleurantes à la surface du corps 2 de carte. Le corps 9 de module comprend un circuit intégré 12 ou puce dont des plots 13 sont électriquement connectés, par des fils métalliques 14, aux plages 11 de contact, l'ensemble, circuit intégré 12 et fils 14, étant enrobé dans une résine 16 de protection et éventuellement renforcé par une feuille d'époxy tandis que la partie supérieure 9 comprend, outre les plages 11 de contact, un support 17 époxy percé de puits destinés au passage des fils 14 pour la connexion du circuit intégré 12 auxdites plages 11.

Selon un aspect particulièrement avantageux de l'invention, le PETG de la seconde couche 6 vient directement au contact du corps 9 de module.

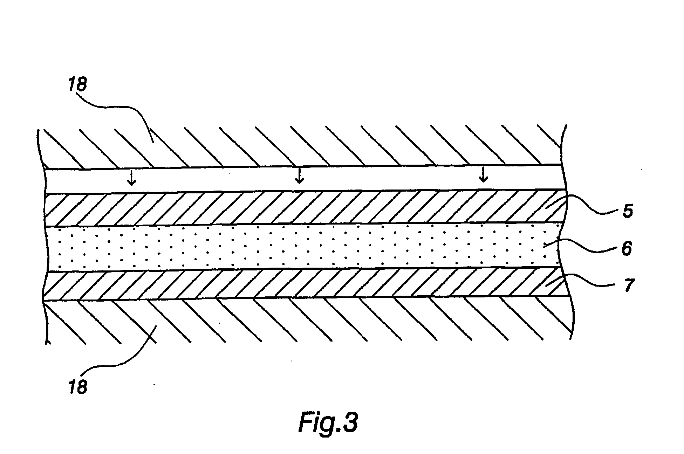

Pour la fabrication d'une carte selon l'invention, on procède de la manière illustrée aux figures 3 à 5.

Ainsi que cela est illustré à la figure 3, on superpose les première 5, seconde 6 et troisième 7 couches entre les plateaux 18 d'une presse de laminage. Puis on soumet l'ensemble superposé à un premier laminage dans des conditions de pression et de température telles que définies dans l'exemple ci-après dans lequel cet ensemble, porté à une température de 115°C, est soumis à une pression de 50 bars pendant 1 minute, puis à une pression croissante linéaire allant de 50 bars à 150 bars pendant 15 minutes. Cette pression de 150 bars est alors maintenue pendant 4 minutes. Par la suite, l'ensemble superposé est soumis à une pression supérieure de 250 bars pendant 17 minutes à température ambiante. On obtient alors un premier ensemble laminé dans lequel les première 5, seconde 6 et troisième 7 couches sont soudées entre elles, les matières plastiques desdites couches ayant atteint leur point Vicat pendant le premier laminage.

Le PETG, dont la viscosité est particulièrement faible une fois que son point Vicat est atteint, est contenu entre les première 5 et seconde 7 couches. Il ne se répand pas entre les plaques 18.

Bien entendu, les étapes ci-dessus du procédé selon l'invention sont préférentiellement mises en oeuvres sur des feuilles de larges dimensions par exemple de l'ordre de 610 mm de long et de 475 mm de large. Les ensembles laminés alors obtenus au moyen de ces feuilles de larges dimensions sont ainsi découpés de manière à obtenir une cinquantaine d'ensembles laminés au format carte.

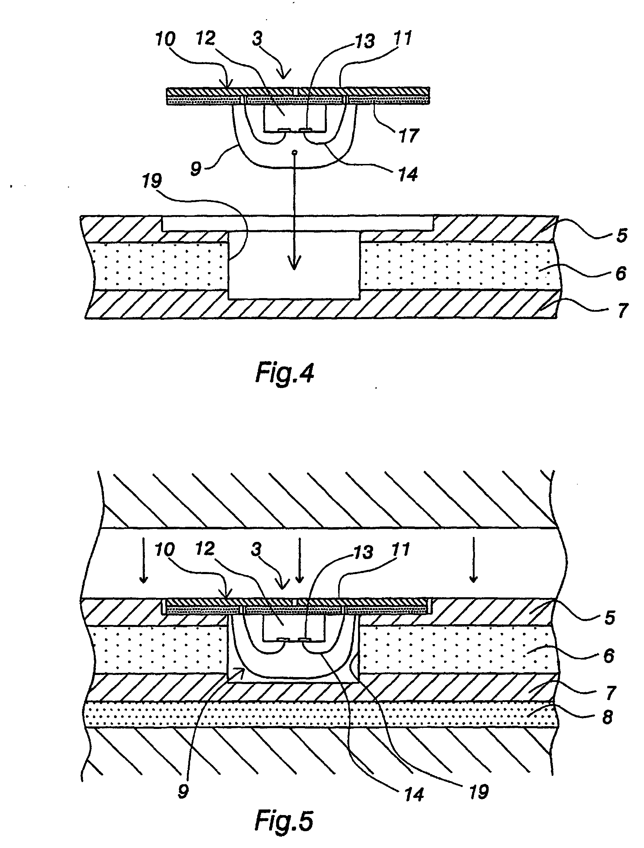

Dans une étape ultérieure selon l'invention illustrée à la figure 4, on ménage, par exemple par fraisage, une cavité 19 dans le premier ensemble laminé. Cette cavité 19, destinée au report du module 3, se présente sous la forme d'un trou non débouchant symétrique de révolution, évasé en sa partie supérieure où il montre un épaulement. Cette cavité 19 traverse la première couche 5 et débouche sur la seconde couche 6. A la figure 4, la cavité 19 débouche dans la seconde couche 6 et atteint la troisième couche 7.

Puis, on reporte le module 3 dans ladite cavité 19. Ce module 3 est en pratique collé dans la cavité 19, la colle étant localisée sur l'épaulement destiné à recevoir la partie supérieure 10 dudit module 3. On obtient finalement un ensemble laminé dans lequel le module 3 a été reporté.

Cet ensemble laminé, comportant le module 3, peut être stocké ou distribué, par des fabricants de cartes, à des administrations ou des sociétés qui souhaitent distribuer de faibles volumes de cartes. Ces administrations ou sociétés sont susceptibles d'être équipées d'outils de laminage et de personnalisation dits de bureau, procédant carte à carte, avec un faible débit

La figure 5 illustre une étape complémentaire selon l'invention qui peut être mise en oeuvre chez ces administrations et sociétés.

Le premier ensemble laminé, comportant le module 3, est directement superposé à la quatrième couche dans un outil de laminage carte à carte. L'ensemble superposé alors obtenu, ou second ensemble superposé, est alors laminé selon un cycle selon lequel ledit ensemble est par exemple porté à 150°C pendant 4 à 5 secondes puis refroidi progressivement jusqu'à 45°C où il est maintenu pendant environ 5 minutes, et ce, à une pression de l'ordre de 4 à 5 bars.

Au cours de ce second laminage, le PETG atteint son point Vicat, se liquéfie et vient combler l'espace compris entre les bords du corps du module et les bords de la cavité. La quatrième couche 8 ne subit alors pas de déformation locale à l'aplomb du module 3 due, dans l'état de la technique, à son écrasement dans l'espace précité. La carte 1 selon l'invention ne présente pas de défaut topologique ou visuel à l'aplomb dudit module. Il est ainsi possible de procéder à une personnalisation physique du corps de carte en imprimant par exemple les motifs 4 sur la couche 8. Dans certaines variantes de réalisation de ladite couche 8, les encres d'impression sont sublimées et migrent au travers de ladite couche 8, ce qui rend la carte 1 plus sécuritaire.

Les cartes 1 selon l'invention se fissurent seulement au bout d'environ 4500 flexions dynamiques en longueur et 4500 flexions dynamiques en largeur avec des flèches respectives de 20 et 10 mm.

Bien entendu, les modes de réalisation décrits ci-dessus sont nullement limitatifs et l'invention peut sans problème s'appliquer à la fabrication de cartes sans contact dans lesquelles le module, généralement formé du circuit intégré est connecté à des bornes d'une antenne noyée dans le corps de carte.

## Revendications

1. Carte (1) comportant un corps (2) de carte comprenant au moins trois couches (5, 6, 7) plastiques laminées directement superposées les unes aux autres, la seconde couche (6) étant une couche de polyéthylène téréphtalate glycol placée entre la première (5) et la troisième (7) couche, lesdites première (5) et troisième couches (7) étant de nature chimique différente de ladite seconde couche (6), un module (3) électronique étant incorporé audit corps (2) de carte, ledit module (3) comprenant un circuit intégré, ladite carte étant **caractérisée en ce que** l'épaisseur de ladite seconde couche (6) est du même ordre de grandeur que celle desdites première et troisième couches.

2. Procédé de fabrication d'une carte (1) comportant un corps (2) de carte comprenant au moins trois couches (5, 6, 7) plastiques laminées directement superposées les unes aux autres, la seconde (6) couche étant une couche de polyéthylène téréphtalate glycol placée entre la première (5) et la troisième (7) couche, lesdites première (5) et troisième couches (7) étant de nature différente de ladite seconde couche (6), un module (3) électronique étant incorporé audit corps (2) de carte, ledit module (3) comprenant un circuit intégré (12), **caractérisé en ce que**,
- on lamine ensemble les première (5), seconde (6) et troisième (7) couches de manière à obtenir un premier ensemble laminé, ladite seconde couche ayant une épaisseur de même ordre de grandeur que celle desdites première et troisième couche ;
- on ménage une cavité débouchant sur la seconde couche ; et
- on reporte le module (3) dans ladite cavité.

3. Procédé selon la revendication 2, **caractérisé en ce que** dans une deuxième étape de laminage, on lamine le système comprenant ledit premier ensemble laminé et ledit module (3 ) de manière à obtenir un second ensemble laminé, ladite deuxième étape de laminage se faisant à des conditions de pression et de température telles que le polyéthylène téréphtalate glycol atteigne son point Vicat.

4. Procédé selon la revendication 3, **caractérisé en ce qu'**on lamine ledit premier ensemble laminé directement superposé à une quatrième couche (8).

## Patentansprüche

1. Karte (1) mit einem mindestens drei, direkt aufeinander gewalzte Kunststoffschichten (5, 6, 7) umfassenden Kartenkörper (2), wobei die zweite Schicht (6) eine Schicht aus Polyethylenterephtalatglykol und zwischen der ersten (5) und dritten (7) Schicht angeordnet ist und die erste (5) und dritte (7) Schicht chemisch gesehen anderer Art sind als die zweite Schicht (6), einem in den besagten Kartenkörper (2) eingebauten Elektronikmodul (3), wobei das Modul (3) einen integrierten Schaltkreis umfasst, **dadurch gekennzeichnet, dass** die Stärke der zweiten Schicht (6) in der gleichen Größenordnung liegt wie die erste und dritte Schicht.

2. Herstellungsverfahren einer Karte (1) mit einem mindestens drei, direkt aufeinander gewalzte Kunststoffschichten (5, 6, 7) umfassenden Kartenkörper (2), wobei die zweite Schicht (6) eine Schicht aus Polyethylenterephtalatglykol und zwischen der ersten (5) und dritten (7) Schicht angeordnet ist und die erste (5) und dritte (7) Schicht chemisch gesehen anderer Art sind als die zweite Schicht (6), einem in den besagten Kartenkörper (2) eingebauten Elektronikmodul (3), wobei das Modul (3) einen integrierten Schaltkreis (12) umfasst, **dadurch gekennzeichnet, dass**
- man die erste (5), zweite (6) und dritte (7) Schicht gemeinsam walzt, um eine erste gewalzte Einheit zu erhalten, wobei die zweite Schicht eine Stärke in der gleichen Größenordnung aufweist wie die erste und dritte Schicht;
- man eine in die zweite Schicht einmündende Vertiefung einarbeitet; und
- man das Modul (3) in diese Vertiefung einsetzt.

3. Verfahren nach Anspruch 2, **dadurch gekennzeichnet, dass** man bei einem zweiten Walzvorgang das aus der ersten gewalzten Einheit und dem besagten Modul (3) bestehende System so walzt, dass man eine zweite gewalzte Einheit erhält, wobei der zweite Walzvorgang unter Druck- und Temperaturbedingungen stattfindet, bei denen Polyethylenterephtalatglykol seinen Vicat-Punkt erreicht.

4. Verfahren nach Anspruch 3, **dadurch gekennzeichnet, dass** man die erste gewalzte Einheit direkt auf einer vierten Schicht liegend (8) walzt.

## Claims

1. Card (1) comprising a card body (2) including at least three laminated plastic layers (5, 6 and 7), directly superimposed on each other, a second layer (6) being a layer in polyethylene terephtalate glycol placed between a first layer (5) and a third layer (7), said first layer (5) and third layer (7) being of a chemical nature different from that of said second layer (6), an electronic module (3) being incorporated in said card body (2), said module (3) comprising an integrated circuit, said card being **characterised in that** the thickness of said second layer (6) is of the same order of magnitude as that of said first and third layers.

2. Manufacturing process for a card (1) comprising a card body (2) including at least three laminated plastic layers (5, 6 and 7) directly superimposed on each other, a second layer (6) being a layer in polyethylene terephtalate glycol placed between a first layer (5) and a third layer (7), said first layer (5) and third layer (7) being of a nature different from that of said second layer (6), an electronic module (3) being incorporated in said card body (2), said module (3) comprising an integrated circuit (12), **characterised in that**,
- first layer (5), second layer (6) and third layer (7) are laminated together so as to obtain a first laminated assembly, said second layer having a thickness of the same order of magnitude as said first and third layers;
- a cavity is created emerging on the second layer; and
- module (3) is inserted in said cavity.

3. Process according to claim 2, **characterised in that** the system comprising said first laminated assembly and said module (3) is laminated during a second laminating step, so as to obtain a second laminated assembly, said second lamination step being executed under pressure and temperature conditions such that the polyethylene terephtalate glycol reaches its Vicat point.

4. Process according to claim 3, **characterised in that** said first laminated assembly is laminated directly superimposed on fourth layer (8).
